## Europäisches Patentamt

## European Patent Office

## Office européen des brevets

(19)

(11) Numéro de publication: **0 111 104**
**A2**

(12) **DEMANDE DE BREVET EUROPEEN**

(21) Numéro de dépôt: **83110253.8**

(22) Date de dépôt: **14.10.83**

(51) Int. Cl.³: **H 01 L 31/02**
**H 01 L 31/06**

(30) Priorité: **12.11.82 CH 6586/82**

(43) Date de publication de la demande:
**20.06.84 Bulletin 84/25**

(84) Etats contractants désignés:
**AT BE CH DE FR GB IT LI LU SE**

(71) Demandeur: **Orsini, Jean**
**30 Calle Hurtado**
**Barcelona(ES)**

(72) Inventeur: **Orsini, Jean**
**30 Calle Hurtado**
**Barcelona(ES)**

(74) Mandataire: **Rinuy, Guy et al,**
**Cabinet Rinuy et Santarelli 14, Avenue de la Grande**
**Armée**
**F-75017 Paris(FR)**

(54) Photobatterie à base de sélénium ou de bore dopé au brome.

(57) La présente invention concerne un dispositif à base de Sélénium ou de Bore ( + Brome) à grande pureté qui récupère et stocke kes électrons provenant de photons.

Ce dispostif a pour but l'utilisation des électrons ainsi "stokés" pour assurer une tension et un courant maximums.

Ce dispositif est constitué par une boite en acier inoxydable étanche pourvue d'une couverture de Photopiles à base de Sélénium ou de Bore (+ Brome) à grande pureté.

La masse statique interne de Sélénium ou de Bore (÷ Brome), compressée à plat, est placée en couches superposées séparées par des lames de cuivre rouge formant l'Anode et le Sélénium ou le Bore (+ Brome) format la cathode, le tout constituant une Photobatterie.

EP 0 111 104 A2

## PHOTOBATTERIE A BASE DE SELENIUM OU DE BORE A GRANDE PURETE DOPE AU BROME

L'objet de l'invention concerne un dispositif récupérateur de photons qui les transforme en électrons et les "stocke" afin de les utiliser ultérieurement.

Il a pour but l'utilisation des électrons "STOCKES" pour assurer un courant maximal avec tension élevée.

La complexité des photopiles au Silicium ne permettait pas auparavant d'obtenir un rendement maximum vu les déperditions des échanges "Photons"-"Electrons".

Selon l'invention la presque totalité des photons sont captés.

Aucun entretien n'est nécessaire.

L'installation peut se poser aussi bien sur une toiture d'habitation que sur un véhicule à moteur électrique.

La photobatterie selon l'invention est constituée par une boite étanche en inox pourvue d'une couverture de photopile a base de Sélénium ou de Bore (+ Brome) à grande pureté; elle est remplie par des lames superposées de cuivre rouge "anodisé" reposant sur une couche de Sélénium ou de Bore (+ Brome) à grande pureté.

Cette photobatterie est un récupérateur d'électrons; elle est constituée de matériaux isothermes. Le bac en inox ou acier inoxydable anti-corrosif est recouvert par une série de photopiles à haute performance (qui ont fait l'objet d'une demande de brevet déposée en SUISSE à la date du 15/IO/82 ayant pour titre "Ilot de Sélénium"). On peut également adapter des "Ilots de Bore (+ Brome) à grande pureté, les résultats de l'Ilot au Bore (+ Brome) étant nettement supérieurs à l'Ilot de Sélénium en raison d'une plus grande perméabilité aux photons.

Le vide est réalisé dans l'espace intercalaire entre le bac et les photopiles constituant la photobatterie.

La masse statique interne Sélénium ou Bore (+ Brome) est compressée à plat en couches minces séparées par les lamelles de cuivre anodisé afin de récupérer le maximum d'électrons et les restituer ensuite lors de l'utilisation.

L'élément principal étant, à la surface du bac, les photopiles (Ilot de Sélénium) ou (Ilot de Bore + Brome) à grande pureté.

L'Anode étant le cuivre anodisé et la Cathode le Sélénium ou le Bore (+ Brome).

Cette installation peut être placée sur une toiture quelconque ou même sur un véhicule qui pourrait être tracté électriquement par un moteur adéquat en raison des tensions et courants importants ainsi obtenus.

## REVENDICATIONS

I - Dispositif récupérateur de photons qui les transforme en électrons afin de les "stocker" sous forme de photobatterie par éléments Sélénium ou Bore (+ Brome) avec lames de cuivre superposées dans un bac en acier inoxydable.

2 - Dispositif suivant la revendication 1 se caractérisant par le fait que la photobatterie est un bac en acier inoxydable étanche rempli par plusieurs couches superposées de Sélénium ou de Bore (+ Brome) intercalées entre les lames de cuivre afin de constituer un récupérateur pour "stockage" d'électrons.

3 - Dispositif suivant la revendication 1 se caractérisant par le fait que le bac étanche de base comprend des photopiles au Sélénium ou au Bore (+ Brome) permettant l'alimentation en courant et tension.

4 - Dispositif selon les revendications 1 et 2, se caractérisant par le fait que les lames de cuivre et les couches de Sélénium ou Bore (+ Brome) sont disposées dans le bac de façon intercalaire.

5 - Dispositif selon les revendications 1, 2, 3, 4 formant ensemble une photobatterie, l'Anode étant le cuivre et la Cathode le Sélénium ou le Bore (+ Brome).